# FASCICULE DE BREVET EUROPEEN

(11) **EP 1 106 039 B1**
(45) Date de publication et mention de la délivrance du brevet: **22.12.2004**
(21) Numéro de dépôt: 00922747.1
(22) Date de dépôt: 25.04.2000
(51) Int. Cl.: H05K 3/40, B23K 20/10

(54) **PROCEDE DE REALISATION D'UN CONTACT ENTRE DEUX COUCHES CONDUCTRICES SEPAREES PAR UNE COUCHE ISOLANTE**
VERFAHREN ZUR HERSTELLUNG EINES KONTAKTS ZWISCHEN ZWEI LEITFÄHIGEN SCHICHTEN DIE DURCH EINE ISOLIERENDE ABSTANDSCHICHT GETRENNT SIND
METHOD FOR PRODUCING A CONTACT BETWEEN TWO CONDUCTIVE LAYERS SEPARATED BY AN INSULATING LAYER

(30) Priorité: 10.05.1999 FR 9905940
(43) Date de publication de la demande: 13.06.2001
(73) Titulaire: Gemplus, 13881 Gémenos Cedex (FR)
(72) Inventeur: MARTIN, Philippe, F-21200 Beaune (FR)
(86) Numéro de dépôt international: PCT/FR2000/001098
(87) Numéro de publication internationale: WO 2000/069237

(56) Documents cités:
- WO-A-99/49708
- DE-A- 19 522 338
- DE-A- 19 618 100

## Description

La présente invention se rapporte aux procédés qui permettent de réaliser des contacts entre deux couches conductrices séparées par une couche isolante.

Plus particulièrement, l'invention s'intéresse à un procédé de réalisation simple rapide et à très bas coût de contacts Ohmiques ou thermiques entre deux couches conductrices séparées par une couche moins conductrice.

Par contact, il faut comprendre, dans le cadre de la description qui va suivre, toute zone de lien entre deux couches qui permet préférentiellement le passage d'un courant (contact Ohmique) ou de chaleur (contact thermique) entre ces deux couches plus conductrices séparées par une couche intermédiaire de moindre conductivité, l'ensemble de toutes les couches étant appelé ci après système et la couche intermédiaire étant appelée ci après support.

Les couches plus conductrices peuvent être par exemple des multicouches métalliques, ou des films, ou des motifs métalliques, en aluminium, en cuivre ou en alliage.

La couche intermédiaire peut être par exemple un film adhésif, un diélectrique, un film isolant, une couche extrudée, un polymère ou tout autre matériau ayant des propriétés diélectriques et/ou conductrices, toute couche de moindre résistivité assurant l'isolement entre les deux couches plus conductrices, ou un ensemble de plusieurs couches de ce type.

Dans la présente demande, on s'intéresse plus particulièrement aux systèmes multicouches de type circuit imprimé flexible double face qui comprennent des motifs métalliques de part et d'autre d'un diélectrique support, motifs qu'il faut relier de manière Ohmique en certains points pour assurer la fonctionnalité du circuit.

Les procédés de contact les plus simples, par exemple par emboutissage, se satisfont d'un contact physique (mécanique) entre les couches conductrices.

Ces procédés peu coûteux et rapides suffisent en général à des systèmes peu sollicités mécaniquement ou requérant une faible fiabilité ou peu contraints en épaisseur, ou robustes mécaniquement, fonctionnant à faible intensité de courant, ou à haute fréquence, ou dont la fonctionnalité tolère la dispersion des caractéristiques Ohmiques du contact, ou dont la constitution favorise la relative bonne qualité du contact.

La réalisation du contact a lieu par déchirement du support et déformation des couches. C'est par exemple le cas du procédé de réalisation des contacts utilisés dans les circuits antivols que l'on trouve dans les magasins. Le diélectrique est fortement élastique et présente des effets de retrait favorables au maintien du contact physique ou de proximité des films métalliques.

Parmi les procédés plus complexes et coûteux, on peut citer le cas des procédés de contact mécaniques par rivetage qui consistent à rapporter une pièce qui fera le lien mécanique par agrafage. La réalisation du contact a lieu par déchirement du support et contact par un élément rapporté.

Pour les procédés les plus complexes, et les plus .coûteux, on obtient des contacts de bonne qualité Ohmique, mais au prix d'un procédé élaboré et contraignant quant à la succession chronologique des étapes constituant le système lui-même, et au choix des matériaux de ce système. La réalisation du contact a lieu par ouverture du support et formation de composés intermétalliques. Le principe de ces procédés est l'adhérence.

C'est par exemple le cas des procédés de contacts de type semi-conducteur ou multicouches hybrides, qui consistent à ouvrir des vias dans le support intermédiaire du système, ces vias débouchant sur la première couche métallique, et à y déposer un alliage métallique constituant la deuxième couche conductrice du système, ces étapes étant souvent complétées par un recuit permettant d'optimiser le lien intermétallique dans le via.

Parmi ces procédés complexes et coûteux, il y a également ceux qui permettent d'obtenir des contacts de bonne qualité Ohmique sur des systèmes préfabriqués sans contact, mais au prix d'étapes supplémentaires, souvent coûteuses et délicates, et d'un apport de matériau intermédiaire supplémentaire permettant d'assurer le lien inter-couches, la performance de ce lien, son maintien dans le temps et sa fiabilité. La réalisation du contact a lieu par découpe du support et ajout d'un matériau intermédiaire. Le principe de ces procédés est le collage.

C'est par exemple le cas des procédés de fabrication de contacts dans les circuits imprimés, qui consistent à ouvrir des vias dans le support séparant les couches conductrices et à y déposer un alliage métallique formant le contact ; le procédé étant souvent complété par un recuit permettant d'optimiser le lien intermétallique entre les couches conductrices. On citera aussi par exemple les solutions utilisées pour les systèmes les plus récents de circuits imprimés flexibles, pour lesquels on utilise une découpe pour l'ouverture des vias, et des colles conductrices comme matériau intermédiaire ; les débordements de ce matériau assurant le contact.

Un problème majeur des procédés "à contact mécanique" ou de ceux du type "à contact par composés intermétalliques" est l'impossibilité d'obtenir simultanément de bons contacts Ohmiques et des coûts de réalisation très faibles, indispensables pour certaines applications ou pour certains produits.

La faiblesse des contacts purement mécanique réside dans la fugacité du contact, dépendant de la qualité de l'emboutissage ou du « rivetage ». La pression est le principe de base de ces procédés. La présence d'un intermédiaire initialement sans via réduit la qualité du contact. Des contraintes environnementales, comme par exemple un laminage ultérieur, nuisent également à la fiabilité de ces contacts. Enfin le choix du matériau support est un des facteurs limitatifs et la clef de la fiabilité de ce type de contact.

Dans l'état de la technique, la dualité coût faible/performance du contact n'était pas accessible jusqu'à présent. Le brevet DE-A-195 22 338 concerne un procédé de réalisation d'un contact entre deux couches conductrices séparées par une couche isolante. Il consiste à presser le complexe formé par ces couches entre un organe excité par les ultrasons et un organe fixe servant de support.

L'invention propose un procédé de réalisation permettant d'obtenir de bons contacts fiables sur les systèmes multicouches ayant au moins deux couches conductrices séparées par au moins une couche intermédiaire de conductivité plus faible (comme par exemple un support isolant), tout en gardant des coûts de réalisation très faibles.

La présente invention a plus particulièrement pour objet un procédé de réalisation d'au moins un contact entre deux couches conductrices séparées par une couche isolante, selon lequel on vient presser le complexe formé par ces couches entre un organe excité par des ultrasons appliqués perpendiculairement à la face du complexe, et un organe fixe ayant une face appuyée sur le complexe caractérisé en ce que la dite face de l'organe fixe comporte des entailles de manière à former au moins une partie saillante apte à déformer le complexe pendant l'application des ultrasons pour permettre le fluage et l'ouverture de la couche isolante au niveau de chaque partie saillante puis la mise en contact et la soudure des couches métalliques au niveau de cette même partie saillante.

Selon une autre caractéristique, on maintient une pression entre l'organe excité par les ultrasons et l'organe fixe après l'arrêt de l'application des ultrasons qui a permis le fluage de la couche isolante, jusqu'au refroidissement et la solidification de la couche isolante.

Selon une autre caractéristique, la surface de l'organe fixe portant chaque partie saillante présente des encoches triangulaires radiales réunies par des arêtes saillantes.

Selon une autre caractéristique, le procédé consiste à transférer le complexe entre un rouleau débiteur et un rouleau récepteur, l'organe fixe présentant la forme d'un rouleau rotatif dont l'axe est parallèle à celui des rouleaux débiteurs et enrouleurs et dont la face latérale est gravée et tourne à une même vitesse adaptée à celle du défilement du complexe.

L'invention couple les avantages des procédés mécaniques, car il n'y a pas d'apport de matière et le procédé est rapide, et les avantages des procédés à contacts par composés intermétalliques, car elle induit une interpénétration métallique des couches à relier.

L'invention, particulièrement bien adaptée pour les claviers réalisés avec des circuits imprimés flexibles, ou pour les transpondeurs à puce micro-électronique à base de circuits résonnants de type circuit imprimé, s'applique à tout type de système.

L'invention ouvre des possibilités de contacts simultanés et directs entre dispositifs électroniques et systèmes à films conducteurs.

L'invention a pour objet un procédé de cisaillement localisé du système à contacter, suivi d'un échauffement et de la formation d'un contact de type soudure par ultrasons dans les zones où les couches conductrices sont en contact physique. La forme de l'outil et sa matière sont étudiés pour permettre à la fois la découpe, l'échauffement du support, la mise en regard des couches conductrices situées de part et d'autre du support, et leur soudure.

Préférentiellement, le système comporte un support en thermo-plastique d'épaisseur inférieure à 100 micromètres (typiquement 25 micromètres) et des motifs métalliques en aluminium, en cuivre, ou en alliage métallique, d'épaisseur inférieure à quelques dizaines de micromètres (typiquement entre 10 et 50 micromètres), situés de part et d'autre du support.

Dans un mode de réalisation préféré, le procédé est mis en oeuvre sur un seul équipement qui permet de réaliser plusieurs contacts simultanément, en mode pas à pas. Une variante de réalisation consiste à réaliser les contacts en continu sur des systèmes en rouleau ou en format.

La réalisation de contacts soudés à travers un support isolant présente de nombreux avantages, en permettant d'éliminer tout ou partie des problèmes cités précédemment. En effet dans ce cas, le contact est parfaitement ohmique (résistance inférieure à 0.1 milliohm), et mécaniquement résistant aux laminages, à des cyclages thermiques, et aux contraintes mécaniques des produits cites ci dessus, (clavier,...).

Ainsi, le problème de fiabilité des contacts est résolu.

Un autre avantage est la finesse du contact, dont la déformation localisée peut être réduite à des valeurs minimales, inférieures par exemple à 200 micromètres.

Dans un cas plus complexe, le système multicouche comporte 2 couches métalliques, par exemple en aluminium, séparées par une couche isolante, par exemple en PET.

L'invention sera mieux comprise, et d'autres particularités et avantages apparaîtront à la lecture de la description qui va suivre, cette description faisant référence aux dessins annexés, parmi lesquels :
- les figures 1a à 1c, représentent des coupes transversales des organes utilisés pendant les trois phases de la mise en oeuvre du procédé selon l'invention ;
- la figure 2, représente une vue en perspective cavalière d'un organe excité par ultrasons et de deux organes fixes utilisés pour mettre en oeuvre le procédé selon l'invention ;
la figure 3, représente une vue en coupe schématique d'une variante de réalisation d'un matériel pour la mise en oeuvre du procédé selon l'invention dans une technique continue.

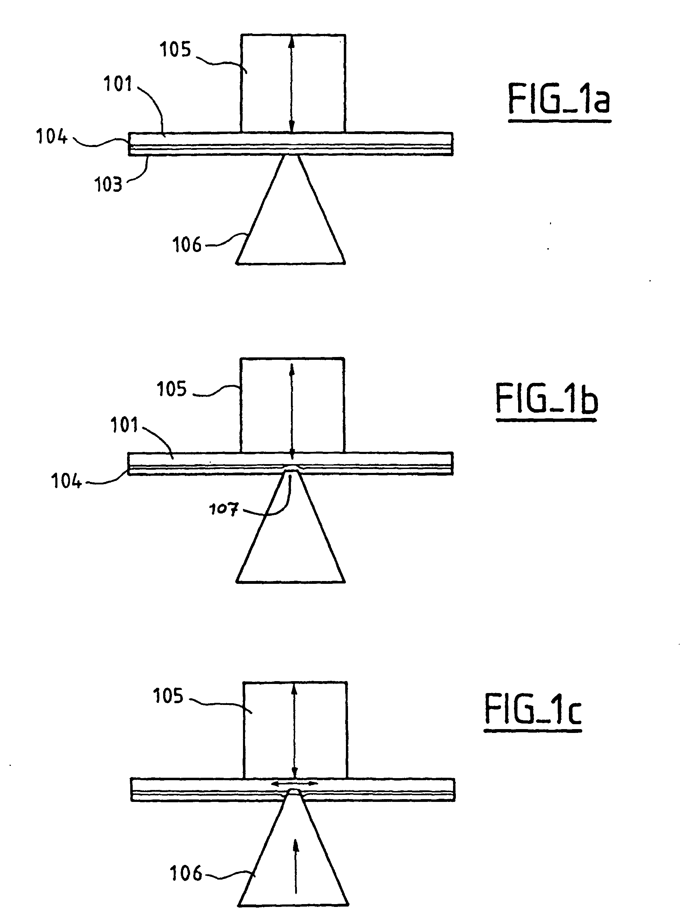

On a représenté sur les figures 1a à 1c les différentes étapes de la mise en oeuvre du procédé selon l'invention dans le cas simple d'une seule soudure de forme sensiblement ronde permettant de relier entre eux électriquement les faces supérieures et inférieures d'un complexe multicouches.

Ce complexe multicouches 101 est formé d'une couche métallique supérieure conductrice 102 et d'une couche métallique conductrice inférieure 103, séparées par une couche isolante 104 thermofusible. Il est mis en place, comme représenté sur la figure la, entre une pièce active 105 qui est l'organe excité par des ultrasons connu sous le nom de « sonotrode » et l'organe fixe 106 dénommé dans la suite par le terme « enclume », les deux pièces étant disposées l'une au-dessus de l'autre.

La sonotrode est, selon l'art connu, une pièce qui peut être mise en vibration par un générateur d'ultrasons. Dans le cas de l'invention ces ultrasons viennent faire vibrer la sonotrode longitudinalement, donc de bas en haut sur la figure 1b.

La face supérieure de l'enclume 106 est entaillée d'une manière qui sera décrite plus loin et qui est représentée sur la figure par une dentelure 107 dont les pointes sont dirigées vers la face plane inférieure de la sonotrode.

Après cette phase de mise en place, représentée sur la figure 1a, le dispositif est mis en fonctionnement de telle manière que les ultrasons font vibrer la sonotrode 105 durant sa descente ou bien dès la mise en contact avec le complexe. Le complexe est mis en pression entre la sonotrode et l'enclume 106, l'enclume appuyant sur la face inférieure du complexe 101.

Sous l'effet des ultrasons, le complexe chauffe et la couche thermoplastique 104 se ramollit. La durée d'application des ultrasons, leur amplitude et leur fréquence sont déterminées en fonction des caractéristiques du complexe 101 avec le cas échéant quelques essais faciles et rapides à mettre en oeuvre.

Le complexe 101 étant ainsi ramolli, les parties saillantes de l'extrémité supérieure de l'enclume viennent le déformer au fur et à mesure que la sonotrode se rapproche de l'enclume.

Alors que les deux couches métalliques sont simplement déformées sans subir de déchirement, la couche thermoplastique centrale flue au niveau de ces parties saillantes, la combinaison du fluage et du ramollissement permet le rapprochement à ce niveau des deux couches métalliques.

Finalement, des forces tangentielles entraînent alors le glissement et la soudure des deux couches métalliques ( par une interpénétration superficielle).

Lorsque la soudure est obtenue, on arrête le fonctionnement de la sonotrode tout en maintenant la pression entre l'enclume et la sonotrode, comme représenté sur la figure 1c.

On maintient cette pression, comme représenté sur la figure 1c, pendant le temps nécessaire au refroidissement et à la re-solidification de la couche thermoplastique. A la fin de ce refroidissement la soudure 108 est préservée, la couche thermoplastique intermédiaire autour de ceux-ci s'étant solidifiée aux endroits où elle a été chassée.

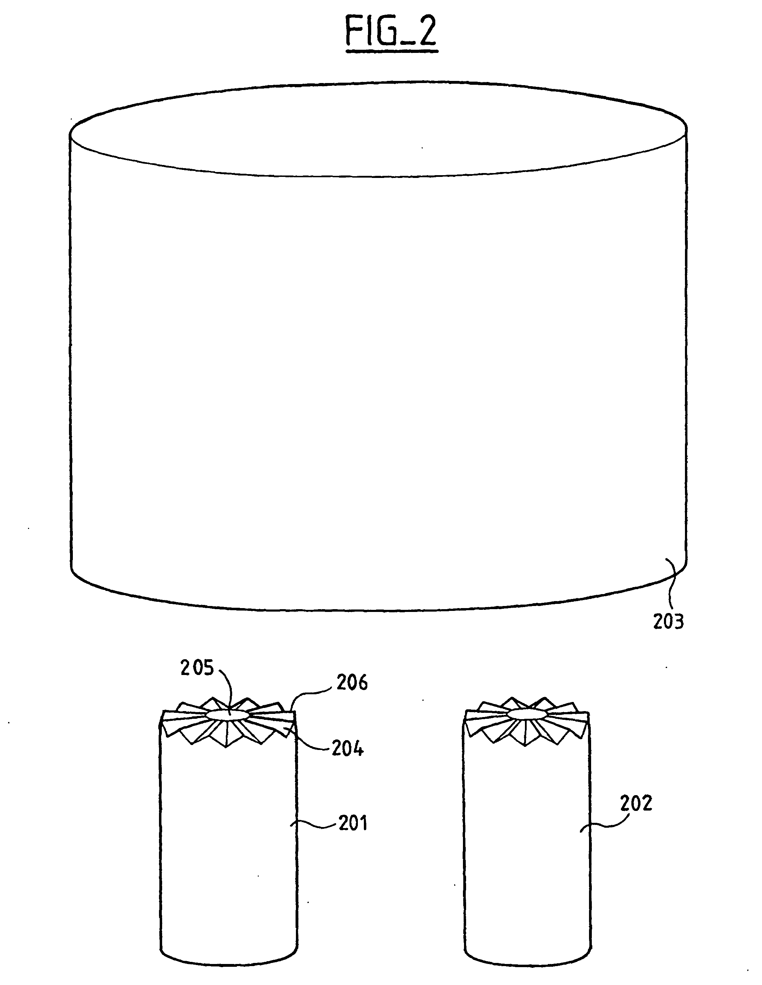

On a représenté sur la figure 2 à titre d'exemple deux enclumes particulières identiques 201 et 202, placées sous une sonotrode commune 203, qui ne présente pas quant à elle de caractéristiques particulières.

Ces deux enclumes sont, à titre d'exemple, de forme cylindrique et comportent à leur partie supérieure une découpe en forme d'entailles radiales 204 de section triangulaire. Ces entailles convergent vers le centre de la face supérieure de l'enclume et se terminent sur une partie circulaire 205 en creux, qui est essentiellement prévue pour faciliter l'usinage de ces entailles. Les parois latérales de ces entailles se rejoignent à leur partie supérieure pour former des arêtes 206, destinées à faciliter la pénétration dans le complexe, ainsi que le fluage et l'ouverture de la couche plastique intermédiaire sous l'effet de la pression importante exercée par les arêtes.

Cet usinage peut s'effectuer de manière à ce que les arêtes 206 soient toutes dans un plan horizontal perpendiculaire à l'axe de l'enclume, ce qui est le plus facile à faire. Toutefois, dans une réalisation préférentielle, on effectuera l'usinage de telle manière que les arêtes 206 présentent une inclinaison descendante vers le centre de la face supérieure de l'enclume de manière à faciliter leur action de pénétration dans le complexe.

De cette manière, le contact obtenu avec une enclume présentant cette forme représentera visuellement la forme d'un ensemble de pétales, douze dans la réalisation décrite, formant des triangles ovalisés dont les pointes sont dirigées vers un centre commun.

Comme représenté sur la figure 2, on peut utiliser un sonotrode de grande dimension en combinaison avec plusieurs enclumes, deux sur la figure 2, pour réaliser simultanément plusieurs contacts. Le cas échéant, on pourra utiliser des enclumes présentant des profils et des sections différents en fonction des contacts à réaliser.

Dans la réalisation décrite ci-dessus le procédé fonctionne essentiellement de manière discontinue, pour former des contacts sur des pièces mises en place et retirées les unes après les autres.

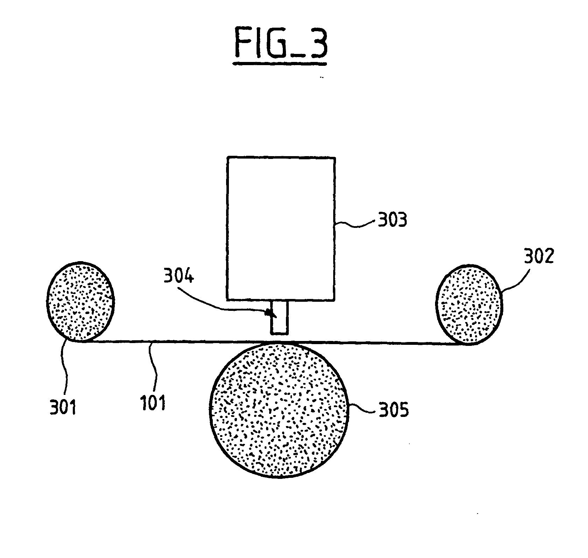

Dans une variante de réalisation, représentée schématiquement sur la figure 3, l'invention propose d'utiliser ce procédé pour former des contacts de manière continue ou quasi continue sur un complexe multicouches de grande longueur qui défile dans un système ad hoc.

Pour cela, ce complexe est déroulé depuis un rouleau débiteur 301 pour passer dans l'équipement de soudure, puis il vient s'enrouler sur un rouleau récepteur 302, lorsque les soudures ont été réalisées.

L'équipement de soudure à ultrasons 303 muni de sa sonotrode 304, est placé au-dessus de l'une des faces du complexe déroulé entre les deux rouleaux.

L'enclume 305 quant à elle est placée sous l'autre face, en regard de la sonotrode.

Dans cette variante de réalisation, l'enclume 305 présente la forme d'un rouleau dont l'axe est parallèle à celui des rouleaux débiteur et récepteur et enrouleurs 301 et 302, et elle vient s'appuyer en permanence sur la face inférieure du complexe tout en tournant pour éviter une friction continue sur cette enclume.

Lorsque l'endroit où l'on souhaite réaliser un contact sur le complexe vient à passer au point de contact entre celui-ci et l'enclume 305, la sonotrode 304 est abaissée rapidement pour venir comprimer à la volée le complexe 101 entre elle-même et l'enclume 305.

Pour pouvoir réaliser le contact de la manière décrite en relation avec la figure 1, la surface de l'enclume rotative 305 présente une gravure adéquate, par exemple des rainures longitudinales, ou un ensemble de pointes qui permettent d'obtenir la déformation souhaitée.

Les ultrasons sont appliqués à la sonotrode 304 avec une intensité importante pendant une durée relativement faible, de manière à ne pas interrompre si possible le mouvement du complexe 101 entre le rouleau débiteur 301 et le rouleau récepteur 302.

Cependant, en fonction des contraintes dues à la structure, aux dimensions et aux caractéristiques des matériaux utilisés, du complexe 101, on pourrait fonctionner pas à pas en arrêtant le mouvement de ce complexe juste le temps nécessaire à la réalisation du contact. On pourrait aussi faire accompagner le mouvement du complexe par la sonotrode en la déplaçant linéairement à la même vitesse pendant l'étape de contact, puis en la ramenant en arrière lorsque les opérations sont terminées.

Le procédé selon l'invention est particulièrement utile pour réaliser des circuits de clavier, plus particulièrement dans sa version continue correspondant à la figure 3.

## Revendications

1. Procédé de réalisation d'au moins un contact entre deux couches conductrices (102, 103) séparées par une couche isolante (104), selon lequel on vient presser le complexe (101) formé par ces couches entre un organe (105) excité par des ultrasons appliqués perpendiculairement à la face du complexe, et un organe fixe (106) ayant une face appuyée sur le complexe **caractérisé en ce que** ladite face de l'organe fixe comporte des entailles de manière à former au moins une partie saillante apte à déformer le complexe pendant l'application des ultrasons pour permettre le fluage et l'ouverture de la couche isolante au niveau de chaque partie saillante puis la mise en contact et la soudure des couches métalliques au niveau de cette même partie saillante.

2. Procédé selon la revendication 1, **caractérisé en ce que** l'on maintient une pression entre l'organe excité par les ultrasons et l'organe fixe après l'arrêt de l'application des ultrasons qui a permis le fluage de la couche isolante, jusqu'au refroidissement et la solidification de la couche isolante.

3. Procédé selon l'une quelconque des revendications 1 et 2, **caractérisé en ce que** la surface de l'organe fixe (201) portant chaque partie saillante présente des encoches triangulaires radiales (204) réunis par des arêtes saillantes (206).

4. Procédé selon l'une quelconque des revendications 1 et 2, **caractérisé en ce que** l'on transfère le complexe (101) entre un rouleau débiteur (301) et un rouleau récepteur (302) et **en ce que** l'organe fixe présente la forme d'un rouleau rotatif (305) dont l'axe est parallèle à celui des rouleaux débiteurs et enrouleurs et dont la face latérale est gravée et qui tourne à une même vitesse adaptée à celle du défilement du complexe.

## Claims

1. A method of producing at least one contact between two conductive layers (102, 103) separated by an insulating layer (104), according to which the complex (101) formed by these layers is pressed between a member (105) excited by ultrasound applied perpendicular to the face of the complex and a fixed member (106) having a face pressed against the complex, **characterised in that** the said face of the fixed member has indentations so as to form at least one projecting part able to deform the complex during the application of the ultrasound to allow the flow and opening of the insulating layer at each projecting part and then the putting into contact and welding of the metallic layer at this same projecting part.

2. A method according to claim 1, **characterised in that** a pressure is maintained between the member excited by the ultrasound and the fixed member after the stoppage of the application of the ultrasound which enabled the flow of the insulating layer, until the insulating layer cools and solidifies.

3. A method according to either one of Claims 1 and 2, **characterised in that** the surface of the fixed member (201) carrying each projecting part has radial triangular notches (204) joined by projecting ridges (206).

4. A method according to either one of claims 1 and 2, **characterised in that** the complex (101) is transferred between a payout roller (301) and a receiving roller (302) and **in that** the fixed member has the form of a rotary roller (305) whose axis is parallel to that of the payout and winding rollers and whose lateral face is etched and which turns at the same speed adapted to that of the movement of the complex.

## Patentansprüche

1. Realisierungsverfahren wenigstens eines Kontakts zwischen zwei durch eine Isolationsschicht (104) getrennte Leiterschichten (102, 103), nach dem der durch diese Schichten gebildete Komplex (101) zwischen einem durch lotrecht auf die Seite des Komplexes angewendeten Ultraschall angeregten Organ (105) und einem festen Organ (106) mit einer auf dem Komplex aufliegenden Seite gepresst wird, **dadurch gekennzeichnet, dass** die genannte Seite des festen Organs Einkerbungen umfasst, so dass wenigstens ein zur Verformung des Komplexes während der Anwendung des Ultraschalls geeigneter hervorspringender Teil gebildet wird, um das Kriechen und die Öffnung der Isolationsschicht an jedem hervorspringenden Teil und anschließend die Herstellung des Kontakts und das Verschweißen der Metallschichten an diesem selben hervorspringenden Teil zu erlauben.

2. Verfahren gemäß Anspruch 1, **dadurch gekennzeichnet, dass** ein Druck zwischen dem durch den Ultraschall angeregten Organ und dem festen Organ nach der Beendigung der Anwendung des Ultraschalls, der das Kriechen der Isolationsschicht erlaubt hat, bis zum Abkühlen und der Verfestigung der Isolationsschicht aufrecht erhalten wird.

3. Verfahren gemäß Anspruch 1 und 2, **dadurch gekennzeichnet, dass** die jeden hervorspringenden Teil tragende Fläche des festen Organs (201) durch hervorspringende Kanten (206) vereinte dreieckige, radiale Aussparungen (204) aufweist.

4. Verfahren gemäß Anspruch 1 und 2, **dadurch gekennzeichnet, dass** der Komplex (101) zwischen eine Abtragsrolle (301) und eine Aufnahmerolle (302) übertragen wird und dass das feste Organ die Form einer rotierenden Rolle (305) aufweist, deren Achse parallel zu den Abtrags- und Aufrollrollen ist und deren laterale Fläche graviert ist und die sich in derselben, an die Geschwindigkeit des Durchlaufs des Komplexes angepassten Geschwindigkeit dreht.
